(19) **Europäisches Patentamt**
**European Patent Office**
**Office européen des brevets**

(11) **EP 1 599 936 B1**

(12) **EUROPÄISCHE PATENTSCHRIFT**

(45) Veröffentlichungstag und Bekanntmachung des Hinweises auf die Patenterteilung:
**19.05.2010 Patentblatt 2010/20**

(21) Anmeldenummer: **04707874.6**

(22) Anmeldetag: **04.02.2004**

(51) Int Cl.:
**H03F 3/45** (2006.01)

(86) Internationale Anmeldenummer:
**PCT/DE2004/000187**

(87) Internationale Veröffentlichungsnummer:
**WO 2004/079898 (16.09.2004 Gazette 2004/38)**

(54) **TRANSIMPEDANZVERSTÄRKER MIT HOHER VERSTÄRKUNGSBANDBREITE ZUM KONVERTIEREN EINES DAC-AUSGANGSSTROMS**

TRANSIMPEDANCE AMPLIFIER WITH A HIGH GAIN BANDWIDTH FOR CONVERTING A DAC-OUTPUT CURRENT

AMPLIFICATEUR DE TRANSIMPEDANCE A GRANDE LARGEUR DE BANDE D'AMPLIFICATION POUR LA CONVERSION D'UN COURANT DE SORTIE DE CONVERTISSEUR NUMERIQUE / ANALOGIQUE

(84) Benannte Vertragsstaaten:
**DE FR GB**

(30) Priorität: **06.03.2003 DE 10309877**

(43) Veröffentlichungstag der Anmeldung:
**30.11.2005 Patentblatt 2005/48**

(73) Patentinhaber: **Infineon Technologies AG**
**85579 Neubiberg (DE)**

(72) Erfinder: **SCHIMPER, Markus**
**85452 Moosinning (DE)**

(74) Vertreter: **Patentanwälte Lambsdorff & Lange**
**Dingolfinger Strasse 6**
**81673 München (DE)**

(56) Entgegenhaltungen:
US-A- 4 642 551    US-A- 5 606 288
US-A- 5 900 779    US-A1- 2002 167 356
US-B1- 6 307 660

**Beschreibung**

Die vorliegende Erfindung betrifft einen Transimpedanzverstärker zur Bereitstellung einer Ausgangsspannung aus einem Eingangsstrom, wobei der Eingangsstrom insbesondere durch den Ausgangsstrom eines Digital-Analog-Wandlers (DAC) gebildet wird.

In drahtlosen Basisbandanwendungen wie z.B. UMTS, WLAN, sowie digitales Fernsehen und Bluetooth werden digitale Daten mit einem Digital-Analog-Wandler (DAC) in analoge Signale gewandelt. Anschließend werden die analogen Signale auf die Trägerfrequenz hochgemischt, nachgefiltert und mit dem Leistungsverstärker über die Antenne an die Luftschnittstelle abgegeben. Bei den genannten Basisbandanwendungen werden Breitband-Modulationsverfahren wie OFDM, DSSS oder andere breitbandige Modulationsverfahren eingesetzt. Diese Modulationsverfahren nutzen die Kanalbandbreite besser aus und erreichen damit höhere Datenraten. An die Linearität, den Phasen- und Dämpfungsverlauf des DAC-Ausgangs werden durch die Breitband-Modulationsverfahren hohe Anforderungen gestellt.

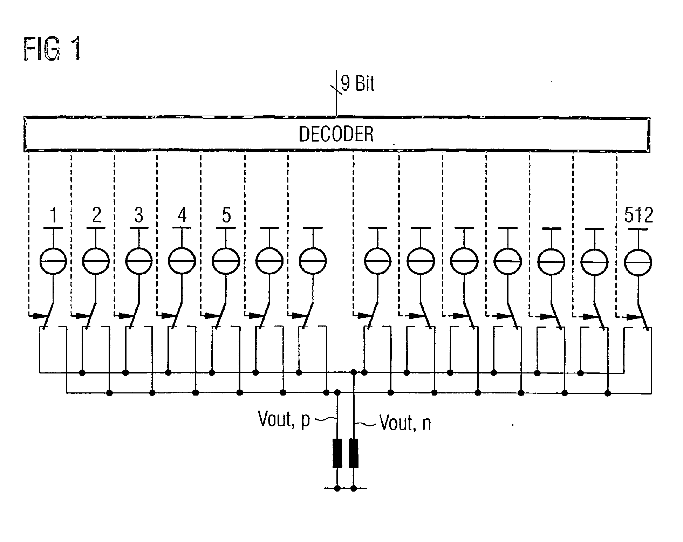

In der Fig. 1 ist ein 9-Bit-Stromquellen-DAC mit 512 Einzelstromquellen dargestellt. Jede Stromquelle besitzt einen Schalter, der ein binäres Signal aus einem Decoder bekommt. Dieses Signal bestimmt, ob eine Stromquelle an den Knoten Vout,p oder an den Knoten Vout,n geschaltet wird. Wenn das digitale Wort um ein LSB (Least Significant Bit) geändert wird, wird eine Stromquelle von Vout,p nach Vout,n geschaltet. Je nach Bitzahl ist der DAC vollsegmentiert oder teilsegmentiert. Wenn am DAC das digitale Wort (000000000) anliegt, sind 512 Stromquellen an Vout,n geschaltet und keine Stromquelle an Vout,p. Bei Vollaussteuerung liegt das digitale Wort (111111111) an, alle Stromquellen sind an Vout,p geschaltet und keine an Vout,n. Wie aus der Fig. 1 zu ersehen ist, werden die Ausgangsströme an den Widerständen in eine differenzielle Ausgangsspannung Voutdiff = Vout,p - Vout,n gewandelt.

Es sind im Stand der Technik verschiedene Schaltungsanordnungen bekannt, mit denen die zwei DAC-Ausgangsströme in eine differenzielle Ausgangsspannung gewandelt werden können. Die einfachste Möglichkeit besteht darin, die Ausgangsströme des DAC direkt an den in der Fig. 1 gezeigten zwei Widerständen in zwei Ausgangsspannungen zu konvertieren. Diese Lösung weist eine hohe Linearität auf und erzeugt keine zusätzlichen Oberwellen. Der Phasen- und Dämpfungsverlauf wird nur durch den Pol, der sich an den Widerständen mit den Lastkapazitäten ergibt, beeinflusst. Eine andere bekannte Schaltungsanordnung verstärkt die Differenzspannung an den DAC-Ausgangswiderständen mit einer invertierenden Differenzverstärkerschaltung. Es hat sich gezeigt, dass mit diesen bekannten Schaltungsanordnungen ein wesentliches Ziel, nämlich die Aufrechterhaltung des Phasen- und Dämpfungsverlaufs nicht zufriedenstellend gewährleistet ist. Hierfür ist es erforderlich, dass der Wandler ein großes Verstärkungsbandbreiteprodukt aufweist und beim Konvertieren des DAC-Ausgangsstroms in die Ausgangsspannung keine zusätzlichen Pole und Nullstellen in die Strom-Spannungs-Transferfunktion eingeführt werden. Die bekannten Schaltungsanordnungen weisen diese Eigenschaften nicht in ausreichendem Maße auf.

US 2002/0167356 A1 offenbart einen differentiellen Verstärker, bei dem eine Miller-Stufe mit einer Stromquelle vorgesehen ist. Ein Teil des Eingangssignals wird in die Stromquelle zurückgekoppelt, um deren Biaspunkt zu verschieben.

Es ist demgemäß Aufgabe der vorliegenden Erfindung, eine Vorrichtung anzugeben, mit der ein Eingangsstrom in eine Ausgangsspannung mit geringem Leistungsverbrauch, einem großen Verstärkungsbandbreiteprodukt und ohne Einführung zusätzlicher Pole und Nullstellen in die Strom-Spannungs-Transferfunktion gewandelt werden kann. Die Vorrichtung soll sich insbesondere dafür eignen, die zwei Ausgangsströme eines Digital-Analog-Stromquellenwandlers in zwei Ausgangsspannungen zu konvertieren.

Diese Aufgabe wird mit den Merkmalen des Patentanspruchs 1 gelöst. Vorteilhafte Weiterbildungen und Ausgestaltungen sind in den Unteransprüchen angegeben.

Die erfindungsgemäße Vorrichtung besteht in einem Transimpedanzverstärker gemäß dem Merkmal des Patentanspruchs 1. Der Transimpedanzverstärker kann so ausgebildet werden, das ihm zwei Eingangsströme zugeführt werden können, welche die zwei Ausgangsströme eines DAC sind, und er als Antwort darauf zwei Ausgangsspannungen bereitstellt.

Der erfindungsgemäße Transimpedanzverstärker weist eine erste Stufe zur Erzeugung eines ersten Spannungssignals aus dem zugeführten Eingangsstrom auf. Weiterhin weist der erfindungsgemäße Transimpedanzverstärker eine zweite Stufe zur Erzeugung eines zweiten Spannungssignals aus dem ersten Spannungssignal auf. Zwischen dem Ausgang der ersten Stufe und dem Ausgang der zweiten Stufe ist ein Kondensator zur Frequenzkompensation gekoppelt. Zwischen dem Eingang und dem Ausgang des Transimpedanzverstärkers ist ein Rückkoppelwiderstand geschaltet.

Wie weiter unten noch näher zu erläutern sein wird, geht der erfindungsgemäße Transimpedanzverstärker aus einem im Stand der Technik bekannten Miller-Operationsverstärker hervor. In einem derartigen Operationsverstärker wird durch Verbinden eines Miller-Kondensators zwischen dem Ausgang einer ersten Verstärkungsstufe und dem Ausgang einer zweiten Verstärkungsstufe eine durch parasitäre Kapazitäten (Miller-Effekt) verursachte Verschlechterung des Frequenzgangs kompensiert (Frequenzkompensation). Bei der voll differenziellen Ausführungsform des erfindungsgemäßen Transimpedanzverstärkers wird ein derartiger Miller-Operätionsverstärker derart modifiziert, indem das Differenzpaar der Eingangstransistoren entfernt und die DAC-Ausgangsströme an derselben Stelle eingespeist werden, an der das Differenzpaar die Ströme eingespeist hat. Durch das direkte Einspeisen der DAC-Ausgangsströme wird das Ausgangssignal nicht mehr verzerrt, da die bei dem Miller-Operationsverstärker infolge der Stromquelle vorhandene Stromlimitierung des Differenzpaares überwunden ist. Aus diesem Grund weist die erfindungsgemäße Transimpedanzverstärker-Schaltung auch keine inhärente Begrenzung der Anstiegsgeschwindigkeit der Ausgangsspannung (Slew Rate) auf, durch die das Ausgangssignal verzerrt wird.

Der erfindungsgemäße Transimpedanzverstärker ist voll differenziell aufgebaut und weist zwei einander symmetrisch aufgebaute Verstärkerschaltungen auf, denen zwei Eingangsströme zuführbar sind und die eine erste und eine zweite Ausgangsspannung erzeugen. Einem derartigen Transimpedanzverstärker können die zwei Ausgangsströme eines Stromquellen-Digital-Analog-Wandlers zugeführt werden.

Gemäß einer weiteren Ausführungsform des erfindungsgemäßen Transimpedanzverstärkers weist die erste Stufe einen ersten Transistor auf, wobei dem Eingangsanschluss des ersten Transistors der Eingangsstrom zugeführt wird, und das Potential des Ausgangsanschlusses des ersten Transistors das erste Spannungssignal bildet.

Gemäß einer weiteren Ausführungsform des erfindungsgemäßen Transimpedanzverstärkers weist die zweite Stufe einen zweiten Transistor auf, wobei das erste Spannungssignal dem Steueranschluss des zweiten Transistors zugeführt wird, und das Potential eines Ausgangsanschlusses des zweiten Transistors das zweite Spannungssignal bildet. Die Ausgangsspannung wird aus dem zweiten Spannungssignal gebildet oder aus ihr abgeleitet.

Gemäß einer weiteren Ausführungsform ist zwischen einem ersten Knotenpunkt, an welchem der Eingangsstrom in die erste Stufe eingekoppelt wird, und einem ersten Bezugspotential eine erste Stromquelle angeordnet, welche insbesondere durch einen Transistor gebildet wird.

Gemäß einer weiteren Ausführungsform ist zwischen einem zweiten Knotenpunkt, an welchem der Kondensator mit dem Ausgang der ersten Stufe verbunden ist, und einem zweiten Bezugspotential eine zweite Stromquelle angeordnet, welche insbesondere durch zwei hintereinander geschaltete Transistoren gebildet wird.

Bevorzugtermaßen weist die erste Stromquelle eine relativ niedrige Ausgangsimpedanz und die zweite Stromquelle eine relativ hohe Ausgangsimpedanz auf.

Gemäß einer weiteren Ausführungsform kann zu dem Miller-Kondensator noch ein zusätzlicher Widerstand in Reihe geschaltet sein. Darüber hinaus kann noch ein weiterer Miller-Kondensator zwischen einem zwischen den Stromquellen-Transistoren befindlichen Knotenpunkt und dem Ausgang des Transimpedanzverstärkers geschaltet sein.

Die Erfindung bezieht sich ebenso auf eine Vorrichtung zur Erzeugung eines analogen Spannungssignals aus einem digitalen Eingangssignal, wobei die Vorrichtung einen erfindungsgemäßen Transimpedanzverstärker und einen Stromquellen-Digital-Analog-Wandler aufweist, dessen Ausgangsstrom dem Transimpedanzverstärker zugeführt wird.

Diese Vorrichtung ist bevorzugtermaßen so aufgebaut, dass der Digital-Analog-Wandler zwei Ausgangsströme erzeugt und der Transimpedanzverstärker, wie vorstehend bereits ausgeführt, als voll differenzielle Schaltung ausgeführt ist, welcher an zwei Eingängen die zwei Ausgangsströme des DAC zugeführt werden und welche als Antwort darauf zwei Ausgangsspannungen erzeugt.

Im Folgenden wird die Erfindung anhand der Zeichnungen im Detail erläutert. Es zeigen:

Fig. 1     ein 9-Bit-Stromquellen-DAC gemäß dem Stand der Technik;

Fig. 2     einen Miller-Operationsverstärker gemäß dem Stand der Technik;

Fig. 3     eine erste Ausführungsform eines erfindungsgemäßen Transimpedanzverstärkers;

Fig.4     eine Hälfte der in Fig. 3 gezeigten Schaltung ohne Rückkopplungswiderstand;

Fig. 5     ein Bodediagramm für eine Ausführungsform eines erfindungsgemäßen Transimpedanzverstärkers;

Fig. 6     eine zweite Ausführungsform eines erfindungsgemäßen Transimpedanzverstärkers;

Fig. 7     eine dritte Ausführungsform eines erfindungsgemäßen Transimpedanzverstärkers.

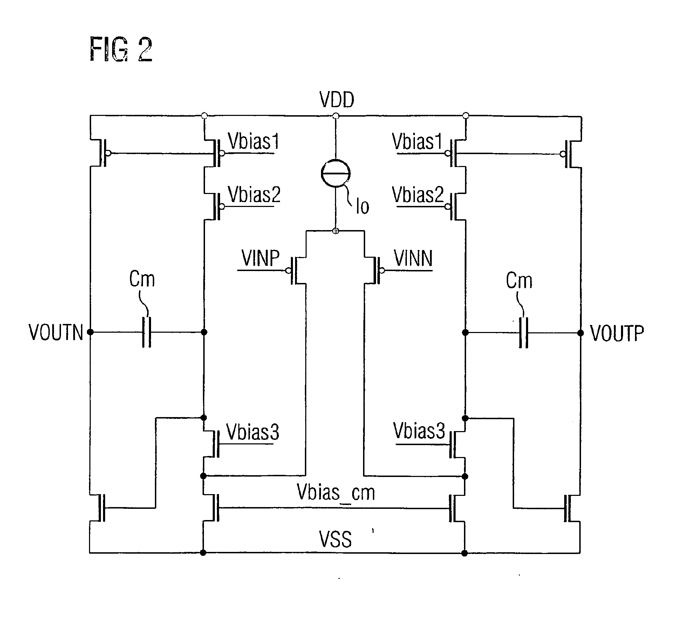

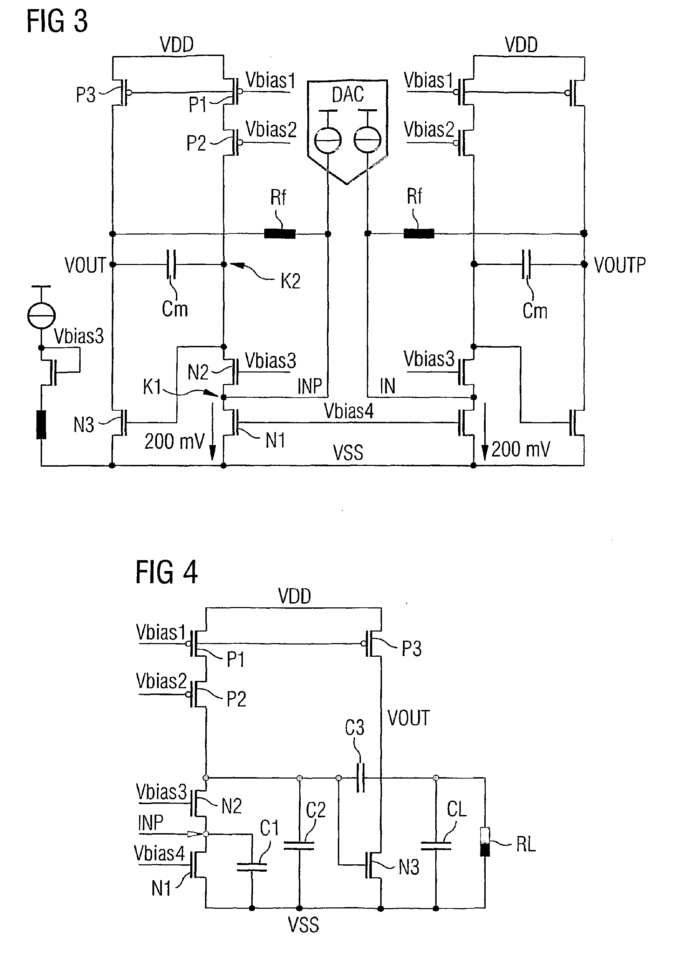

In der Fig. 2 ist ein konventioneller Miller-Operationsverstärker nach dem Stand der Technik dargestellt. Dem Operationsverstärker werden zwei Eingangsspannungen VINP und VINN zugeführt und in zwei Ausgangsspannungen VOUTN und VOUTP gewandelt. Die beiden Eingangsspannungen VINP und VINN werden jeweils an die Steuerelektrode (Gate) von Transistoren einer Differenzverstärker-Eingangsstufe angelegt. Den Transistoren wird der Strom aus einer Stromquelle Io zugeführt. Die weitere Beschreibung erfolgt anhand der Fig. 3.

In der Fig. 3 ist eine erste Ausführungsform eines erfindungsgemäßen Transimpedanzverstärkers dargestellt. Eine wesentliche Änderung gegenüber dem Operationsverstärker der Fig. 2 besteht darin, dass das Differenzpaar der Eingangsverstärkerstufe entfernt wird und Eingangsströme an der selben Stelle eingespeist werden, an der das Differenzpaar die Ströme Ip und In eingespeist hat. Als Eingangsströme INP und IN dienen im dargestellten Fall die zwei Ausgangsströme eines Stromquellen-DAC, wie eingangs anhand der Fig. 1 erläutert worden ist. Die Schaltung ist symmetrisch aufgebaut, so dass die Eingangsströme INP und IN zwei identisch aufgebauten Verstärkerschaltungen zugeführt werden. Infolge der direkten Einspeisung der DAC-Ausgangsströme wird bei dem erfindungsgemäßen Transimpedanzverstärker das Ausgangssignal nicht mehr verzerrt, da die Stromlimitierung des Differenzpaares durch die Stromquelle Io eliminiert worden ist. Daher besitzt der erfindungsgemäße Transimpedanzverstärker keine inhärente Limitierung der Anstiegsgeschwindigkeit der Ausgangsspannung (Slew Rate), durch die das Ausgangssignal verzerrt wird.

Die Eingangsströme werden jeweils einem Eingangsanschluss eines ersten Transistors N2 zugeführt, welcher in seiner Beschaltung als Kaskode-Transistor wirkt. Das Potential am Ausgangsanschluss des ersten Transistors N2 wird an die Steuerelektrode eines zweiten Transistors N3 angelegt, der zwischen die zwei Versorgungsspannungen VSS und VDD geschaltet ist. Das sich an dem Elektrodenanschluss des zweiten Transistors N3 auf der Seite der Versorgungsspannung VDD einstellende Potential bildet die Ausgangsspannung des Transimpedanzverstärkers.

Bei dem erfindungsgemäßen Transimpedanzverstärker der Fig. 3 wie auch bei dem Miller-Operationsverstärker der Fig. 2 ist zwischen dem Ausgang der ersten Stufe, also am Ausgang des ersten Transistors N2, und dem Ausgang der zweiten Stufe, im vorliegendem Fall also dem Ausgang des Transimpedanzverstärkers, aus Gründen der Frequenzkompensation eine sogenannte Miller-Kapazität Cm geschaltet.

Eine weitere wesentliche Modifikation gegenüber dem Miller-Operationsverstärker der Fig. 2 besteht darin, dass zwischen dem Eingang und dem Ausgang des Transimpedanzverstärkers ein Rückkoppelwiderstand Rf geschaltet ist. In beiden symmetrischen Zweigen der in der Fig. 3 gezeigten Ausführungsform ist somit jeweils eine Verbindungsleitung zwischen den Ausgangsanschlüssen und den die Eingangsströme INP und IN führenden Eingangsanschlüssen mit jeweils einem Rückkoppelwiderstand Rf gelegt.

Der Transimpedanzverstärker der Fig. 3 weist keine Gleichtaktregelung auf. Der Ausgangsgleichtaktpegel wird durch die Spannung an dem Kaskodetransistor N2 und durch den statischen Ausgleichsstrom, der durch den Rückkoppelwiderstand Rf fließt, eingestellt. Die Spannung an dem Rückkoppelwiderstand Rf ist nur dann konstant, wenn alle Ströme, die die Arbeitspunkte an den Transistoren in dem Transimpedanzverstärker einstellen, und die DAC-Ausgangsströme proportional zur Band-Gap-Spannung und reziprok zum Rückkoppelwiderstand sind. Die Transistoren P1 und P2 bilden eine Stromquelle relativ hoher Ausgangsimpedanz. Der Transistor N1 ist eine Stromquelle mit verminderter Ausgangsimpedanz. Durch den Kaskodetransistor N2 ist garantiert, dass der Summationspunkt exakt 200 mV über dem Versorgungspotential VSS liegt. Der oben erwähnte Ausgleichsstrom durch den Rückkoppelwiderstand Rf wird mit der Stromquelle P1/P2 und der durch den Transistor N1 gebildeten Stromquelle eingestellt. Sind die Ströme zwischen P1/P2 und N1 ungleich, dann fließt $\Delta$I durch den Rückkoppelwiderstand Rf. Mit diesem Effekt kann der Gleichtaktpegel eingestellt werden.

Anhand der Fig. 4 sollen die Eigenheiten der neuen Miller-Frequenzkompensation für den erfindungsgemäßen Transimpedanzverstärker näher erläutert werden. Die dargestellte Schaltung ist eine der zwei Hälften der in Fig. 3 gezeigten symmetrischen Transimpedanzverstärker-Schaltung ohne Rückkopplungswiderstand. Der Miller-Kondensator Cm ist in dieser Darstellung durch den Kondensator C3 gegeben. Zusätzlich berücksichtigt ist eine am Ausgang des Transimpedanzverstärkers angeschlossene Last, die durch einen Lastkondensator CL und einen dazu parallel geschalteten Lastwiderstand RL repräsentiert ist.

Wenn man eine Kleinsignalanalyse mit der Y-Matrixmethode der in Fig. 4 gezeigten Schaltung durchführt, so kommt man auf die stabilitätsbestimmende Schleifenverstärkung A*β ist eine Gleichung mit zwei Nullstellen und vier Polen.

$$A\beta = \frac{Y_{21}Y_{21}}{Y_{11}Y_{22}} = \frac{gm_{N2}gm_{N3}(1 + s / z_1)(1 - s / z_2)}{gds_{N2}g_L(1 + s / p_1)(1 + s / p_2)(1 + s / p_3)(1 + s / p_4)}$$

Die Gleichungen für die zwei Nullstellen:

$$z_1 = \frac{gds_{N2}}{C_3}$$

$$z_2 = \frac{gm_{N3}}{C_3}$$

Die Gleichungen für die vier Pole:

$$p_1 = \frac{gds_{N2}}{R_f gm_{N2} C_3}$$

$$p_2 = \frac{g_L gds_{N2}}{gm_{N2} C_3}$$

$$p_3 = \frac{gm_{N3}}{C_L\left(1 + \dfrac{C_2}{C_3}\right) + C_2}$$

$$p_4 = \frac{gm_{N2}}{C_1}$$

$$GBW = \frac{1}{R_f C_3}$$

Tabelle 1

| Bauteile | Parameter 1 | Parameter 2 |
|---|---|---|
| NMOS-transistor N1 | $gds_{N1} = 1.35mS$ | |
| NMOS-transistor N2 | $gds_{N2} = 450\mu S$ | $gm_{N2} = 18.3mS$ |
| NMOS-transistor N3 | $gds_{N3} = 2.5mS$ | $gm_{N3} = 65mS$ |
| PMOS-transistor P1 | $gds_{p1} = 180\mu S$ | |
| PMOS-transistor P2 | $gds_{p2} = 150\mu S$ | $gm_{P2} = 13mS$ |
| PMOS-transistor P3 | $gds_{p3} = 165\mu S$ | |
| Kapazität C1 | $C_1 = 2pF$ | |
| Kapazität C2 | $C_2 = 400fF$ | |
| Kapazität C3 | $C_3 = 10pF$ | |
| Kapazität CL | $C_L = 20pF$ | |

(fortgesetzt)

| Bauteile | Parameter 1 | Parameter 2 |
|---|---|---|
| Widerstand Rf | $R_f = 600\Omega$ | |
| Widerstand RL | $R_L = 1k\Omega$ | |

Aus den in Tabelle 1 aufgeführten Kleinsignalparametern ergeben sich die in Tabelle 2 veranschaulichten Pole und Nullstellen.

Tabelle 2

| Nullstellen | |
|---|---|
| $z_1 = \dfrac{450\mu S}{10pF} = 45\,\text{Mrad / s}$ | $z_2 = \dfrac{65mS}{10pF} = 6.5\,\text{Grad / s}$ |
| **Pole** | |
| $p_1 = \dfrac{450\mu S}{600\Omega \cdot 18.3mS \cdot 10pF} = 4.1\,\text{Mrad / s}$ <br><br> $p_3 = \dfrac{65mS}{20pF} = 3.35\,\text{Grad / s}$ | $p_2 = \dfrac{450\mu S \cdot 5.16mS}{18.3mS \cdot 10pF} = 25\,\text{Mrad / s}$ <br><br> $p_4 = \dfrac{18.3mS}{2pF} = 9.15\,\text{Grad / s}$ |
| **Verstärkungsbandbreiteprodukt** | |
| $GBW = \dfrac{1}{600\Omega \cdot 2pF} = 166\,\text{Mrad / s}$ | |

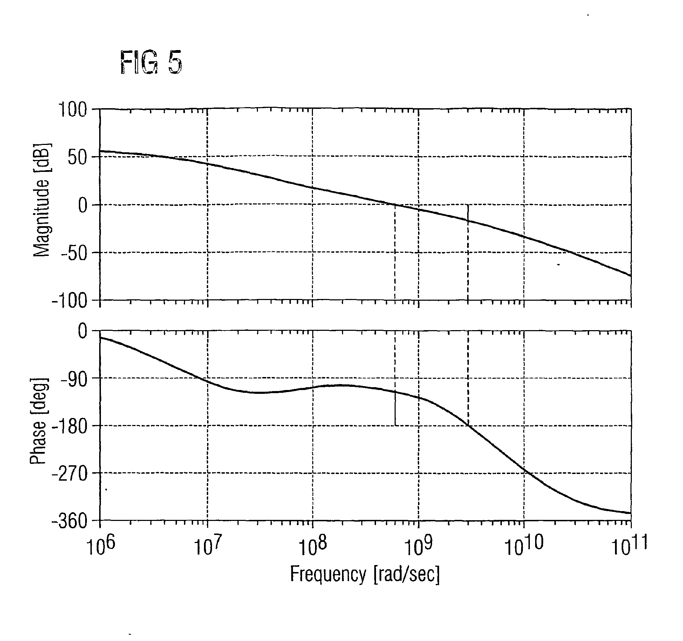

In der Fig. 5 ist das Bodediagramm für die in der Tabelle 1 und 2 beschriebene Ausführungsform eines erfindungsgemäßen Transimpedanzverstärkers dargestellt. Wie in dem Diagramm zu sehen ist, hat der Verstärker eine Phasenreserve von 67˚. Wird die Nullstelle $Z_2$ mit einem Widerstand in Reihe zu dem Miller-Kondensator kompensiert, erreicht man eine Phasenreserve von 70˚.

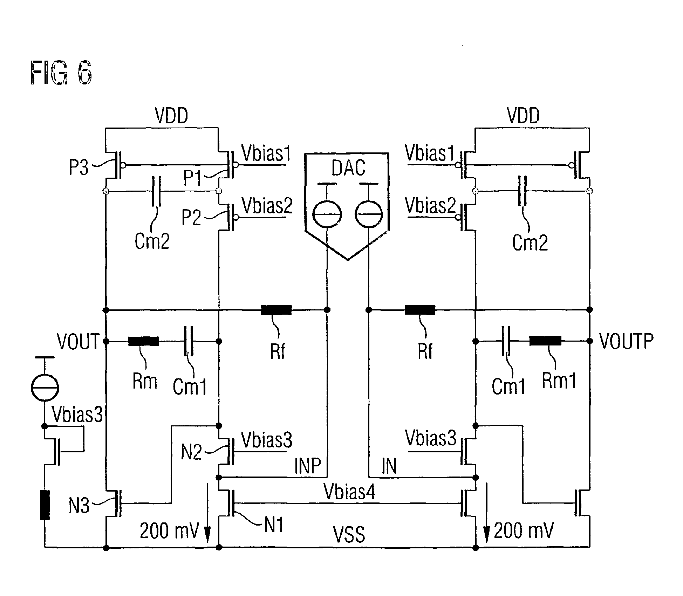

Eine zweite Ausführungsform eines erfindungsgemäßen Transimpedanzverstärkers ist in der Fig. 6 dargestellt. Bei dieser Schaltung wird nicht nur ein zusätzlicher Widerstand Rm in Reihe zu dem Miller-Kondensator Cm1 geschaltet, sondern auch ein zusätzlicher Miller-Kondensator Cm2 zwischen dem Ausgang des Transimpedanzverstärkers und einem zwischen den Stromquellen-Transistoren P1 und P2 befindlichen Knotenpunkt geschaltet.

Die Frequenzkompensation des erfindungsgemäßen Transimpedanzverstärkers ist der Frequenzkompensation eines zweistufigen Millerverstärkers ähnlich. Die Nullstelle $Z_2$ und der dominante Pol $p_2$ und der nicht-dominante Pol $p_3$ sind äquivalent zu den Polen und Nullstellen in dem Millerverstärker. Der Transimpedanzverstärker hat im Frequenzbereich vor dem Verstärkungsbandbreiteprodukt GBW noch den Pol $p_1$ und die Nullstelle $z_1$. Der Pol $p_1$ liegt um den Faktor $R_f \cdot gm_{N2}$ vor der Nullstelle $z_1$. Es muss sichergestellt sein, dass die Frequenz der Nullstelle $z_1$ 4-5 mal niedriger ist als das Verstärkungsbandbreiteprodukt GBW. Dies wird erreicht, indem man $gds_{N2}$ 4 - 5 mal kleiner als $1/R_f$ wählt. Das Verstärkungsbandbreiteprodukt GBW ist durch den Miller-Kondensator $C_3$ und durch den Rückkoppelwiderstand $R_f$ bestimmt. Die Schaltung hat noch einen zweiten nicht-dominanten Pol $p_4$, der um den Faktor 2 höher als $P_3$ liegen sollte.

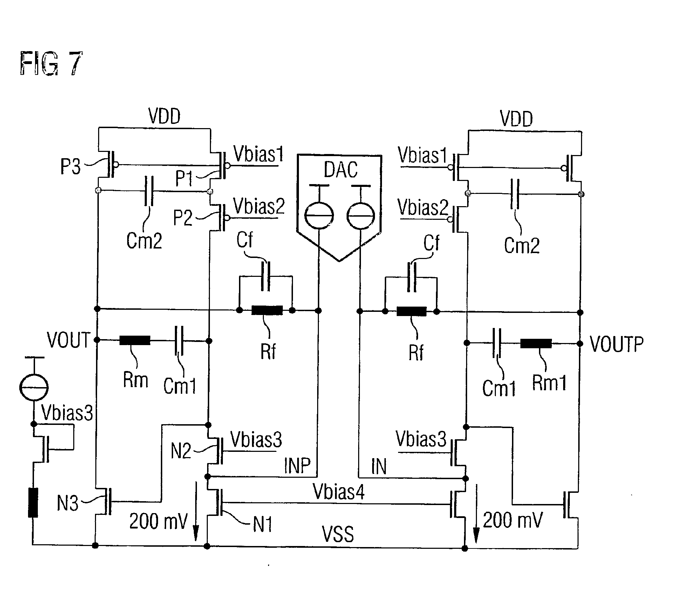

Eine dritte Ausführungsform eines erfindungsgemäßen Transimpedanzverstärkers ist in der Fig. 7 dargestellt. Bei dieser Schaltung wird zusätzlich zu der in der Fig.6 gezeigten Ausführungsform noch ein weiterer Kondensator Cf zu dem Rückkoppelwiderstand Rf parallel geschaltet. Es kann in ebensolcher Weise bei den in Fig.3 und Fig.4 gezeigten Ausführungsformen vorgesehen sein, dass zu den Rückkoppelwiderständen Rf jeweils ein weiterer Kondensator Cf parallel geschaltet wird.

**Patentansprüche**

1. Transimpedanzverstärker zur Bereitstellung einer Ausgangsspannung aus einem Eingangsstrom, mit:

   - einem ersten Eingang, an dem ein Eingangsstrom zuführbar ist;
   - einer mit dem ersten Eingang direkt gekoppelten ersten Stufe zur Erzeugung eines ersten Spannungssignals aus dem dem ersten Eingang zugeführten Eingangsstrom (INP, IN),
   - einer direkt mit der ersten Stufe gekoppelten zweiten Stufe zur Erzeugung eines zweiten Spannungssignals aus dem von der ersten Stufe erzeugten ersten Spannungssignal,
   - einem Kondensator (Cm; C3) zur Frequenzkompensation, welcher direkt zwischen einem Ausgang der ersten Stufe und einem Ausgang der zweiten Stufe gekoppelt ist, und
   - einem Rückkoppelwiderstand (Rf), welcher direkt zwischen dem ersten Eingang des Transimpedanzverstärkers und dem Ausgang der zweiten Stufe gekoppelt ist, wobei dem Transimpedanzverstärker zwei Eingangsströme (INP, IN) zuführbar sind, und der Transimpedanzverstärker ferner zwei einander symmetrisch aufgebaute Verstärkerschaltungen zur Erzeugung einer ersten (VOUT) und einer zweiten Ausgangsspannung (VOUTP) enthält.

2. Transimpedanzverstärker nach Anspruch 1,
   **dadurch gekennzeichnet, dass**

   - die erste Stufe einen ersten Transistor (N2) aufweist, wobei dem Eingangsanschluss des ersten Transistors (N2) der Eingangsstrom zugeführt wird und das Potential des Ausgangsanschlusses des ersten Transistors (N2) das erste Spannungssignal bildet.

3. Transimpedanzverstärker nach einem der vorhergehenden Ansprüche,
   **dadurch gekennzeichnet, dass**
   die zweite Stufe einen zweiten Transistor (N3) aufweist und das erste Spannungssignal dem Steueranschluss des zweiten Transistors (N3) zugeführt wird und das Potential einer An-Anschlusselektrode des zweiten Transistors (N3) das zweite Spannungssignal bildet.

4. Transimpedanzverstärker nach einem der vorhergehenden Ansprüche,
   **dadurch gekennzeichnet, dass**

   - zwischen einem ersten Knotenpunkt (K1), an welchem der Eingangsstrom in die erste Stufe eingekoppelt wird, und einem ersten Bezugspotential (VSS) eine erste Stromquelle (N1) angeordnet ist, welche insbesondere durch einen Transistor gebildet wird.

**5.** Transimpedanzverstärker nach einem der vorhergehenden Ansprüche,
**dadurch gekennzeichnet, dass**

- zwischen einem zweiten Knotenpunkt (K2), an welchem der Kondensator (Cm) mit dem Ausgang der ersten Stufe verbunden ist, und einem zweiten Bezugspotential (VDD) eine zweite Stromquelle (P1, P2) angeordnet ist, welche insbesondere durch zwei hintereinander geschaltete Transistoren gebildet wird.

**6.** Transimpedanzverstärker nach Anspruch 4 und 5,
**dadurch gekennzeichnet, dass**

- eine Ausgangsimpedanz der ersten Stromquelle (N1) geringer als eine Ausgangsimpedanz der zweiten Stromquelle (P1, P2) ist.

**7.** Transimpedanzverstärker nach einem der vorhergehenden Ansprüche,
**dadurch gekennzeichnet, dass**

- ein Widerstand (Rm) zu dem Kondensator (Cm) in Reihe geschaltet ist.

**8.** Transimpedanzverstärker nach Anspruch 5,
**dadurch gekennzeichnet, dass**

- ein weiterer Kondensator (Cm2) zwischen einem zwischen den Stromquellen-Transistoren (P1, P2) befindlichen Knotenpunkt und dem Ausgang des Transimpedanzverstärkers gekoppelt ist.

**9.** Transimpedanzverstärker nach einem der vorhergehenden Ansprüche,
**dadurch gekennzeichnet, dass**

- dem Rückkoppelwiderstand (Rf) ein Kondensator (Cf) parallel geschaltet ist.

**10.** Vorrichtung zur Erzeugung eines analogen Spannungssignals aus einem digitalen Eingangssignal, mit

- einem Stromquellen-Digital-Analog-Wandler (DAC), welchem das digitale Eingangssignal zugeführt wird, und
- einem Transimpedanzverstärker nach einem der vorhergehenden Ansprüche, welchem der Ausgangsstrom des Digital-Analog-Wandlers (DAC) zugeführt wird.

**11.** Vorrichtung nach Anspruch 10, bei welcher

- der Digital-Analog-Wandler (DAC) zwei Ausgangsströme liefert und einem Transimpedanzverstärker nach Anspruch 2 zuführt.

**Claims**

**1.** Transimpedance amplifier for production of an output voltage from an input current, having

- a first stage, directly coupled to the first input, for production of a first voltage signal from the input current (INP, IN) supplied to the first input,
- a second stage, directly coupled to the first stage, for production of a second voltage signal from the first voltage signal produced by the first stage,
- a capacitor (Cm; C3) for frequency compensation, which is coupled directly between an output of the first stage and an output of the second stage, and
- a feedback resistor (Rf), which is coupled directly between the first input of the transimpedance amplifier and the output of the second stage, in which the transimpedance amplifier can be supplied with two input currents (INP, IN) and the transimpedance amplifier further contains two mutually symmetrical amplifier circuits for production of a first (VOUT) and of a second (VOUTP) output voltage.

**2.** Transimpedance amplifier according to Claim 1,
**characterized in that**

- the first stage has a first transistor (N2), with the input current being supplied to the input connection of the first transistor (N2), and with the potential at the output connection of the first transistor (N2) forming the first voltage signal.

**3.** Transimpedance amplifier according to one of the preceding claims,
**characterized in that**

- the second stage has a second transistor (N3) and the first voltage signal is supplied to the control connection of the second transistor (N3), and the potential at a connecting electrode of the second transistor (N3) forms the second voltage signal.

**4.** Transimpedance amplifier according to one of the preceding claims,
**characterized in that**

- a first current source (N1), which is formed in particular by a transistor, is arranged between a first node (K1), at which the input current is injected into the first stage, and a first reference ground potential (VSS).

**5.** Transimpedance amplifier according to one of the preceding claims,
**characterized in that**

- a second current source (P1, P2), which is formed in particular by two series-connected transistors, is arranged between a second node (K2), at which the capacitor (Cm) is connected to the output of the first stage, and a second reference ground potential (VDD).

**6.** Transimpedance amplifier according to Claim 4 and 5,
**characterized in that**

- an output impedance of the first current source (N1) is less than an output impedance of the second current source (P1, P2).

**7.** Transimpedance amplifier according to one of the preceding claims,
**characterized in that**

- a resistor (Rm) is connected in series with the capacitor (Cm).

**8.** Transimpedance amplifier according to Claim 5,
**characterized in that**

- a further capacitor (Cm2) is coupled between a node, which is located between the current source transistors (P1, P2), and the output of the transimpedance amplifier.

**9.** Transimpedance amplifier according to one of the preceding claims,
**characterized in that**

- a capacitor (Cf) is connected in parallel with the feedback resistor (Rf).

**10.** Apparatus for production of an analog voltage signal from a digital input signal, having

- a current source digital/analog converter (DAC) to which the digital input signal is supplied, and
- a transimpedance amplifier according to one of the preceding claims, to which the output current from the digital/analog converter (DAC) is supplied.

**11.** Apparatus according to Claim 10, in which

- the digital/analog converter (DAC) produces two output currents and supplies them to a transimpedance amplifier according to Claim 2.

**Revendications**

1. Amplificateur de transimpédance pour disposer d'une tension de sortie à partir d'un courant d'entrée, comprenant :

   - une première entrée, à laquelle peut être envoyé un courant d'entrée ;
   - un premier étage couplé directement à la première entrée et destiné à la production d'un premier signal de tension à partir du courant (INP, IN) d'entrée envoyé à la première entrée,
   - un deuxième étage couplé directement au premier étage et destiné à la production d'un deuxième signal de tension à partir du premier signal de tension produit par le premier étage,
   - un condensateur (Cm, C3) pour la compensation de la fréquence, qui est monté directement d'une sortie du premier étage à une sortie du deuxième étage, et
   - une résistance (Rf) de réaction, qui est montée directement de la première entrée de l'amplificateur de transimpédance à la sortie du deuxième étage, dans lequel deux courants (INP, IN) d'entrée peuvent être envoyés à l'amplificateur de transimpédance et l'amplificateur de transimpédance comporte, en outre, deux circuits amplificateurs de constitution symétrique l'un par rapport à l'autre pour la production d'une première (VOUT) tension et d'une deuxième (VOUTP) tension de sortie.

2. Amplificateur de transimpédance suivant la revendication 1,
   **caractérisé en ce que**

   - le premier étage a un premier transistor (N2), le courant d'entrée étant envoyé à la borne d'entrée du premier transistor (N2) et le potentiel de la borne de sortie du premier transistor (N2) formant le premier signal de tension.

3. Amplificateur de transimpédance suivant l'une des revendications précédentes,
   **caractérisé en ce que**
   le deuxième étage a un deuxième transistor (N3) et le premier signal de tension est envoyé à la borne de commande du deuxième transistor (N3) et le potentiel d'une électrode de borne du deuxième transistor (N3) forme le deuxième signal de tension.

4. Amplificateur de transimpédance suivant l'une des revendications précédentes,
   **caractérisé en ce que**

   - entre un premier point (K1) nodal, où le courant d'entrée est injecté dans le premier étage, et un premier potentiel (VSS) de référence, est montée une première source (N1) de courant, qui est formée notamment par un transistor.

5. Amplificateur de transimpédance suivant l'une des revendications précédentes,
   **caractérisé en ce que**

   - entre un deuxième point (K2) nodal, où le condensateur (Cm) est relié à la sortie du premier étage, et un deuxième potentiel (VDD) de référence, est montée une deuxième source (P1, P2) de courant, qui est formée notamment par deux transistors montés l'un derrière l'autre.

6. Amplificateur de transimpédance suivant les revendications 4 et 5,
   **caractérisé en ce que**

   - une impédance de sortie de la première source (N1) de courant est plus petite qu'une impédance de sortie de la deuxième source (P1, P2) de courant.

7. Amplificateur de transimpédance suivant l'une des revendications précédentes,
   **caractérisé en ce que**

   - une résistance (Rm) est montée en série avec le condensateur (Cm).

8. Amplificateur de transimpédance suivant la revendication 5,

**caractérisé en ce que**

- un autre condensateur (Cm2) est monté entre un point nodal se trouvant entre les conducteurs (P1, P2) formant source de courant et la sortie de l'amplificateur de transimpédance.

9. Amplificateur de transimpédance suivant l'une des revendications précédentes,
**caractérisé en ce que**

- un condensateur (Cf) est monté en parallèle à la résistance (Rf) de réaction.

10. Dispositif de production d'un signal de tension analogique à partir d'un signal d'entrée numérique, comprenant :

- un convertisseur (DAC) numérique-analogique de source de courant, auquel est envoyé le signal numérique d'entrée, et
- un amplificateur de transimpédance suivant l'une des revendications précédentes, auquel est envoyé le courant de sortie du convertisseur (DAC) numérique-analogique.

11. Dispositif suivant la revendication 10, dans lequel

- le convertisseur (DAC) numérique-analogique fournit deux courants de sortie et les envoie à un amplificateur de transimpédance suivant la revendication 2.

## FIG 1

FIG 2

## FIG 3

## FIG 4

FIG 5

FIG 6

## FIG 7

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20020167356 A1